# EUROPEAN PATENT APPLICATION

(11) **EP 3 492 546 A1**
(43) Date of publication of application: **05.06.2019**
(21) Application number: 17833940.4
(22) Date of filing: 26.06.2017
(51) Int. Cl.: C09K 3/14, B24B 37/00, C09G 1/02, H01L 21/304

(54) **ABRASIVE GRAINS, MANUFACTURING METHOD THEREFOR, POLISHING SLURRY CONTAINING SAID ABRASIVE GRAINS, AND POLISHING METHOD USING SAID POLISHING SLURRY**

(30) Priority: 28.07.2016 JP 2016148247; 09.12.2016 JP 2016239892
(71) Applicant: Baikowski Japan Co., Ltd., Narashino-shi, Chiba 275-0001 (JP)
(72) Inventor: HOSOI, Daisuke, Narashino-shi Chiba 275-0001 (JP); MACHIDA, Shingo, Narashino-shi Chiba 275-0001 (JP); SHIGETA, Takashi, Narashino-shi Chiba 275-0001 (JP)
(74) Representative: Plougmann Vingtoft a/s
(86) International application number: PCT/JP2017/023456
(87) International publication number: WO 2018/020931

(57) **Abstract**

An abrasive composed of additive-coated inorganic abrasive particles having a positive zeta potential at pH 8 or lower. The additive is preferably a picolinic acid or a glutamic acid. The inorganic abrasive particles are preferably cerium oxide particles. The abrasive composed of cerium oxide particles coated with a picolinic acid or a glutamic acid and having a positive zeta potential at pH 8 or lower is a product produced by a method including wet grinding cerium oxide in the presence of the picolinic acid or the glutamic acid.

## Description

### Technical Field

This invention relates to abrasive grains, a method for producing the same, a polishing slurry containing the same, and a polishing method using the polishing slurry.

### Background Art

Chemical mechanical planarization (CMP) is a known process in which mechanical polishing using an abrasive is combined with chemical polishing that corrodes, alters, or otherwise acts on the surface of a workpiece to improve the polishing rate and quality. CMP is frequently used in a planarization process in semiconductor fabrication, a planarization process in power device fabrication, a planarization process in acoustic device (such as SAW (surface acoustic wave) devices and BAW (bulk acoustic wave) devices) fabrication, a planarization process in sensor (such as position sensors, angle sensors, acceleration sensors, and magnetic sensors) fabrication, and a planarization process in optical device (such as LEDs and LDs) fabrication.

CMP has a difficulty in simultaneously increasing the production speed while preventing the occurrence of defects, and substrate processing has been a cause of the increase of production cost.

Patent Literature 1 below discloses an abrasive for polishing a surface including a surface of silicon oxide and a surface of metal. According to the technique of Patent Literature 1, polishing at a controlled polishing rate is achieved to provide a planarized surface without defects.

### Citation List

### Patent Literature:

Patent Literature 1: US 2013029489(A1)

### Summary of Invention

However, with the recent growth in performance of devices, it has been sought to further improve the polishing rate while reducing the occurrence of defects. Patent Literature 1 is silent on a dispersant which may be used in grinding cerium oxide particles obtained by firing a high-purity cerium salt and the condition of adding the dispersant.

The present invention provides an abrasive grain comprising a cerium oxide particle coated with a picolinic acid or a glutamic acid and having a positive zeta potential at pH 8 or lower. The present invention also provides the abrasive grain produced by a method comprising wet grinding cerium oxide in the presence of the picolinic acid or the glutamic acid.

The present invention also provides a polishing slurry comprising the abrasive grain.

The present invention also provides a method for polishing a surface, comprising polishing the surface using the polishing slurry.

The present invention also provides a method for producing the abrasive grain, the method comprising wet grinding cerium oxide in the presence of a picolinic acid or a glutamic acid.

### Brief Description of Drawings

Fig. 1(a) is a schematic plan view of an STI patterned test substrate to be polished using the polishing slurry of the invention. Fig. 1(b) is a schematic enlarged fragmentary view of the STI patterned test substrate.
Fig. 2 is an enlarged cross-sectional view of the STI patterned test substrate shown in Fig. 1.

### Description of Embodiments

The invention will be described on the basis of its preferred embodiment. The invention relates to an abrasive comprising additive-coated inorganic abrasive particles having a positive zeta potential at pH 8 or lower. Specifically, the present embodiment relates to an abrasive composed of cerium oxide particles coated with a picolinic acid or a glutamic acid and having a positive zeta potential at pH 8 or lower. The invention also relates to a polishing slurry containing additive-coated inorganic abrasive particles having a positive zeta potential at pH 8 or lower. Specifically, the embodiment relates to a polishing slurry containing an abrasive composed of cerium oxide particles coated with a picolinic acid or a glutamic acid and having a positive zeta potential at pH 8 or lower. The invention also relates to a polishing slurry containing abrasive grains, an additive, and water, the abrasive grains being composed of cerium oxide particles coated with a picolinic acid or a glutamic acid and having a positive zeta potential at pH 8 or lower, and the additive being capable of developing a positive charge in the polishing slurry.

In the invention, cerium oxide (CeO₂) particles, which exemplify the inorganic abrasive particles, serve as an abrasive. The cerium oxide particle may be, for example, those obtained by firing high-purity cerium carbonate or nitrate having a purity of 99 mass% or higher as the starting material, followed by grinding. Alternatively, the cerium oxide particle may be colloidal ceria obtained by a process involving no firing, i.e., by slurrying cerium hydroxide in water and subjecting the slurry to a hydrothermal treatment in an autoclave at 100°C or higher under autogenic pressure. Preferred of them for use as abrasive grains of the embodiment are particles obtained by firing high-purity cerium nitrate as the starting material, followed by grinding. This preference is based on the assumption that when using cerium nitrate in the firing step, more acid-base sites (chemical adsorption sites) are developed on the surface of cerium oxide particles to be obtained thereby to promote coating with a picolinic acid or a glutamic acid.

With a view to improving the polishing rate while reducing defects and to ensure the dispersion stability in the polishing slurry, the cerium oxide particles preferably have an average particle size D₅₀ of 5 to 1000 nm, more preferably 8 to 150 nm, and even more preferably 10 to 100 nm. As used herein, the term "average particle size D₅₀" refers to the diameter at 50% of the cumulative volume distribution measured by the laser diffraction/scattering particle size distribution analysis.

The cerium oxide particles preferably have a narrow particle size distribution with a view to securing ease of handling and effectively providing desired characteristics. Specifically, the ratio of D₉₀ (the diameter at 90% of the cumulative volume distribution) to D₅₀ (the diameter at 50% of the cumulative volume distribution), D₉₀/ D₅₀, is preferably 1.0 to 5.0, more preferably 1.0 to 3.0.

Examples of the inorganic abrasive particles suitable for use as abrasive grains in the invention other than cerium oxide (CeO₂) particles include silica particles, alumina particles, titania particles, and zirconia particles. Cerium oxide (CeO₂) particles are the most preferred in view of obtaining a high polishing rate on an oxide film as a surface to be polished.

The inorganic abrasive particles of the invention are coated with an additive. The additive coating on the inorganic abrasive particles is capable of imparting a positive charge to the inorganic abrasive particles in a polishing slurry. Additives capable of imparting the inorganic abrasive particle to have a positive charge include cationic surfactants, amphoteric surfactants, amine salts, and amino acids. A picolinic acid or a glutamic acid is preferably used in terms of high capability of coating the inorganic abrasive particles to impart a positive charge to the particles in a pH range of the polishing slurry being used, e.g., pH 5 to 6, improving the dispersibility of the particles, being free of Na or K, being less likely to cause reduction in a polishing rate, and improving antifoaming properties. In the embodiment, the cerium oxide particles as an abrasive grain are coated with a picolinic acid or a glutamic acid.

Specific examples of the picolinic acid that can coat the cerium oxide particles include picolinic acid, 6-methylpicolinic acid, 6-ethylpicolinic acid, 3-cyclopropylpicolinic acid, 4-cyclopropylpicolinic acid, 6-cyclopropylpicolinic acid, 5-butylpicolinic acid, and 6-cyclobutylpicolinic acid. Preferred among them is picolinic acid in view of ease of coating the cerium oxide particles. These picolinic acids may be used either individually or in combination thereof.

The amount of the picolinic acid coating the cerium oxide particles is preferably 0.07 to 7 mass%, more preferably 0.35 to 5.6 mass%, even more preferably 0.7 to 2.1 mass%, relative to the mass of uncoated cerium oxide with the view of increasing the polishing rate while preventing the occurrence of defects. The amount of the picolinic acid coating may be determined by, for example, neutralization titration. Having a large amount of the picolinic acid coating, the coated cerium oxide particles as the abrasive grains of the embodiment exhibit self-dispersibility and hardly allow the picolinic acid to come off the cerium oxide particles despite the strong physical force applied during polishing, thereby accomplishing stable polishing. The good dispersibility leads to prevention of agglomeration of the abrasive grains or polishing waste. As a result, polishing defects, such as scratches, reduce markedly, and the above described effects of improving the polishing rate while preventing the occurrence of defects are thus achieved.

Examples of the glutamic acid that can coat the cerium oxide particles include glutamic acid, N-acetylglutamic acid, N-methyl-L-glutamic acid, and dicarboxymethylglutamic acid. Preferred among them is glutamic acid for ease of coating the cerium oxide particles. These glutamic acids may be used either individually or in combination thereof.

The amount of the glutamic acid coating the cerium oxide particles is preferably 0.07 to 7 mass%, more preferably 0.35 to 5.6 mass%, even more preferably 0.7 to 2.1 mass%, relative to the mass of uncoated cerium oxide in view of increasing the polishing rate while preventing the occurrence of defects. The amount of the glutamic acid coating the cerium oxide particles may be determined by, for example, neutralization titration. Since the amount of the glutamic acid coating the cerium oxide particle is large similarly to the amount of the picolinic acid coating the cerium oxide particle as the abrasive grain of the embodiment, the abrasive grain exhibit excellent self-dispersibility, and, accordingly, formation of agglomerates involving polishing waste generated during polishing is prevented. As a result, the polishing waste is driven out of the system smoothly. The above described effects of improving the polishing rate while preventing the occurrence of defects are thus achieved.

In the invention, the picolinic acid and the glutamic acid may be used in combination. When they are used in combination, the total amount of the picolinic acid and the glutamic acid coating the cerium oxide particle is preferably 0.07 to 7 mass%, more preferably 0.35 to 5.6 mass%, even more preferably 0.7 to 2.1 mass%, relative to the mass of uncoated cerium oxide.

The abrasive grain of the invention comprises an inorganic abrasive particle having a positive zeta potential at pH 8 or lower. The abrasive grain of the embodiment comprises cerium oxide particles having a surface condition such that the zeta potential of the particles is positive as measured in an aqueous solution adjusted to a pH of 8 or lower. The cerium oxide particles preferably have a surface condition such that the zeta potential of the particle is positive even when measured in an aqueous solution adjusted to a pH higher than 8. While it is preferred for remarkably producing the effects of the invention that the zeta potential be positive in the entire range of a pH of 8 or lower, the effects of the invention are sufficiently produced in so far as the zeta potential is positive in a pH range of from 3 to 8. The absolute value of the zeta potential in an aqueous solution adjusted to pH 8 is not particularly limited as long as it is positive, and a higher zeta potential is more preferred. Specifically, the zeta potential at pH 8 is preferably +10 mV or higher, more preferably +20 mV or higher. The zeta potential at pH lower than 8, for example, in an aqueous solution adjusted to pH 7, is not particularly limited as long as it is positive, and a higher zeta potential is more preferred. Specifically, the zeta potential at pH 7 is preferably +20 mV or higher, more preferably +30 mV or higher. As stated above, the zeta potential is preferably positive even at a pH higher than 8. Specifically, the zeta potential is preferably positive at a pH higher than 8 and not higher than 9. For example, a higher zeta potential measured in an aqueous solution adjusted to pH 9 is more preferred. Specifically, the zeta potential at pH 9 is preferably greater than +0 mV. The maximum zeta potential practically reachable by cerium oxide particles in an aqueous solution adjusted to any pH value would be about +60 mV. Note that the terms "pH" and "zeta potential" as used herein are values measured in an aqueous solution containing the abrasive grain kept at 25°C. The term "zeta potential" as used herein denotes a potential measured at the slip plane between the charged cerium oxide particle and the solution, which can be measured by streaming potential measurement, electrophoresis, or the like.

The effect of the abrasive grain of the embodiment having a positive zeta potential is considered as follows: when the surface of a workpiece to be polished has a negative zeta potential, the cerium oxide particles as an abrasive grain are easily adsorbed electrostatically onto the surface to provide so many cutting edges, whereby chemical mechanical polishing is accelerated. Conversely, if the zeta potential of the surface to be polished is positive, the opposite effect may result. Nevertheless, the contrast between the strong and weak effects may be taken advantage of in controlling precision polishing characteristics.

The zeta potential of the abrasive grain of the invention is measured in a solution of the grain in water as a dispersing medium, the solution having its pH adjusted by varying the amount of a pH adjustor added, such as nitric acid, acetic acid, potassium hydroxide, or aqueous ammonia. The water as a dispersing medium is preferably pure water prepared by filtering ion-exchanged water through a filter or distilled water.

The zeta potential measurement can be taken using an instrument based on the principle of electrophoretic light scattering, such as Zeta-potential & Particle Size Analyzer ELSZ series available from Otsuka Electronics Co., Ltd.

The pH measurement can be taken using, for example, pH/Ion Meter D51 (electrode model: 9625-10D) from Horiba, Ltd.

The inventors have found that cerium oxide particles (A) obtained by wet grinding cerium oxide in the presence of a picolinic acid or a glutamic acid are coated with a larger amount of the picolinic acid or the glutamic acid than cerium oxide particles (B) obtained by wet grinding cerium oxide in distilled water in the presence of an anionic surfactant, such as polyacrylic acid, that has conventionally been used as a dispersant in the art and then adding a picolinic acid or a glutamic acid to the system. The fact that a large amount of a picolinic acid or a glutamic acid deposits on the surface of cerium oxide particles is obvious from the results of Examples 1 and 7 given later.

Since the abrasive grain of the embodiment is composed of cerium oxide particles coated with a large amount of a picolinic acid or a glutamic acid, it is capable of improving the polishing rate while preventing the occurrence of polishing defects as is apparent from the description of Examples 1 and 7 in comparison with the cerium oxide particles of Comparative Examples 1 to 3.

As used herein, the expression "inorganic abrasive particle coated with an additive" and equivalent expressions mean that the additive exists directly on the surface of an inorganic abrasive particle having undergone no surface treatment. Specifically, the expression "cerium oxide (particle) coated with a picolinic acid or a glutamic acid" and equivalent expressions mean that the picolinic acid or the glutamic acid exists directly on the surface of a cerium oxide particle having undergone no surface treatment. Therefore, cerium oxide particles having undergone any surface treatment before being coated with a picolinic acid or a glutamic acid are excluded from the "cerium oxide (particles) coated with a picolinic acid or a glutamic acid" as referred to in the invention. What is meant by the term "surface treatment" as referred to herein includes treatments with various dispersants, including anionic surfactants, such as polyacrylic acid, as exemplified above. The inventors consider that coating of a cerium oxide particle with a picolinic acid or a glutamic acid is achieved by an adsorptive force (i.e., a physical binding force, such as Van der Waals force) exerted by the surface of the cerium oxide particle, by which a picolinic acid or a glutamic acid is attracted to the cerium oxide particle and adsorbed thereon, or by a chemical binding force (e.g., covalent bond, ionic bond, or coordinate bond) that results from electron transfer between the picolinic or glutamic acid molecule and the surface of the cerium oxide particle and acts between them more strongly than the physical binding force. The inventors further consider that the new surface produced by grinding fired cerium oxide exhibits so high surface activity that a picolinic acid or a glutamic acid tends to be adsorbed thereon preferentially, so that chemical adsorption with a strong binding force involving electron transfer occurs more than electrostatic physical adsorption.

Under ordinary circumstances, the inventors are supposed to investigate and clarify the factors that bring about the improvement in polishing rate while preventing the occurrence of defects, specifically, the reason of the surface of cerium oxide particles being coated with a picolinic acid or a glutamic acid successfully; whether or not the adsorption phenomenon, which is considered as one cause of the coating behavior, is physical adsorption and/or chemical adsorption; a cause of adsorption, if any, other than adsorption; the condition (structure) of a picolinic acid or a glutamic acid coating the surface of cerium oxide particles; and the like factors, thereby enabling the inventors to determine the characteristics or structure of the picolinic or glutamic acid-coated cerium oxide particles and to describe the characteristics or structure in a claim for an invention of a product.

However, determining the characteristics or structure to be described in a product claim required significant financial expenditure and time to implement, and it was technically impossible to determine and describe the characteristics or structure in a claim at least at the time of filing the application for patent.

Considering that promptness is needed in view of the nature of patent application, the abrasive grain of the claimed invention is defined by reciting a manufacturing process (a method for producing an abrasive grain comprising wet grinding cerium oxide in the presence of a picolinic acid or a glutamic acid) in a product-by-process claim instead of describing the characteristics.

Thus, there existed impossible circumstances, i.e., circumstances in which it is impossible to directly define the abrasive grain of the invention on the basis of its structure or characteristics at the time of filing the application for patent.

The abrasive grain of the embodiment comprising cerium oxide particles coated with a picolinic acid or a glutamic acid and capable of improving the polishing rate while preventing the occurrence of defects can be produced efficiently by a method including the step of wet grinding cerium oxide in the presence of a picolinic acid or a glutamic acid as discussed above with respect to cerium oxide particles (A). It is difficult with cerium oxide particles having been coated with a picolinic acid or a glutamic acid through physical adsorption to greatly improve the polishing rate and prevent the occurrence of defects. The essential characteristics of the invention reside in that a picolinic acid or a glutamic acid is caused to coat to form a strongly adsorbed species. Specifically, the wet grinding of cerium oxide in the presence of a picolinic acid or a glutamic acid is carried out as follows: a picolinic acid or a glutamic acid is added to water as a liquid medium that may contain a small amount of a polymeric dispersant commonly used in the art, such as polyacrylic acid-based dispersant, but is preferably free of such a dispersant; cerium oxide and the liquid medium are put in a bead mill together with 1 to 3 mm-diameter beads made, e.g., of zirconia; and wet grinding is performed in the presence of the added picolinic acid or glutamic acid that functions as a dispersant for the cerium oxide particles. The grinding time is adjusted according to the throughput. The wet grinding conditions are preferably decided so that the resulting abrasive grains may preferably have, as described above, an average particle size D₅₀ of 5 to 1000 nm, more preferably 8 to 150 nm, even more preferably 10 to 100 nm, and the ratio of D₉₀ (the diameter at 90% of the cumulative volume distribution) to D₅₀ (the diameter at 50% of the cumulative volume distribution), D₉₀/ D₅₀, of 1.0 to 3.0.

Cerium oxide to be wet ground according to the method of the invention preferably has a 50% cumulative volume particle diameter D₅₀ of 1 to 30 µm, more preferably 1 to 20 µm. The D₅₀ of cerium oxide to be wet ground is measured in the same manner as for the D₅₀ of the cerium oxide particles as the abrasive grain of the embodiment, namely the wet-ground cerium oxide particles.

With a view to achieving efficient production of the abrasive grain of the invention, the ratio of the cerium oxide being wet ground to the dispersing medium, i.e., water is preferably 0.1 to 50 mass%, more preferably 5 to 45 mass%, even more preferably 10 to 40 mass%.

With a view to achieving efficient production of the abrasive grain of the invention, the amount of the picolinic acid to be added is preferably 0.1 to 10 mass%, more preferably 0.5 to 8 mass%, even more preferably 1 to 3 mass%, relative to the mass of the cerium oxide particles to be coated with the picolinic acid.

With a view to achieving efficient product of the abrasive grain of the invention, the amount of the glutamic acid to be added is preferably 0.1 to 10 mass%, more preferably 0.5 to 8 mass%, even more preferably 1 to 3 mass%, relative to the mass of the cerium oxide particles to be coated with the glutamic acid.

The abrasive grain of the invention as produced by the above described method may serve as such as a polishing slurry of the invention. Otherwise, the dispersion of the abrasive grain as produced by the method may be used as diluted with a dispersing medium, such as water, for use as a polishing slurry of the invention. In either case, the polishing slurry may contain various additives hereinafter described according to necessity. That is, the polishing slurry of the invention comprises an abrasive grain, an additive, and water, the abrasive grain being composed of an additive-coated inorganic abrasive particle having a positive zeta potential at pH 8 or lower, and the additive being capable of developing a positive charge in the polishing slurry. Specifically, the polishing slurry of the present embodiment contains cerium oxide particles, a picolinic acid or a glutamic acid, and water. The cerium oxide particle is coated with the picolinic or glutamic acid that is capable of imparting a positive charge to the cerium oxide particle in the polishing slurry. The coated cerium oxide particle has a positive zeta potential at pH 8 or lower. The pH and zeta potential as referred to here are those measured in an aqueous solution containing the abrasive grain kept at 25°C.

In view of providing an improved polishing rate while reducing the occurrence of defects and securing dispersion stability, the cerium oxide content of the polishing slurry thus produced is preferably 0.1 to 20 mass% relative to the slurry.

In view of providing a good balance between improvement of a polishing rate and reduction in defects, the pH of the polishing slurry of the invention is preferably 3 to 9, more preferably 5 to 8, even more preferably 6 to 8. The pH value as referred to here is the value measured in the polishing slurry kept at 25°C. A slurry at a pH of 3 or lower is unfavorable in terms of polishing rate because the pH value is close to the isoelectric point of a silicon oxide film being polished. At a pH of 9 or higher, the cerium oxide particles would agglomerate and settle out, which is unfavorable in terms of product stability and polishing defects. A slurry having a pH within the range of from 6 to 8 provides a high industrial value because it realizes the capability of achieving both improvement in polishing rate and great reduction of polishing defects, such as scratches.

An additive capable of causing the inorganic abrasive grain to have a positive charge in the slurry may further be added to the polishing slurry of the embodiment. Hereinafter, the additive that can be added to the polishing slurry will be called a post-additive and distinguished from the additive coating the inorganic abrasive particle described above. Addition of a post-additive capable of causing the inorganic abrasive particle to have a positive charge in the polishing slurry improves the polishing rate on not only a blanket film, i.e., a film with a uniform thickness, but also a patterned wafer. Examples of such a post-additive capable of causing the inorganic abrasive particle to have a positive charge include cationic surfactants, amphoteric surfactants, amine salts, and amino acids similarly to the additives coating the inorganic abrasive particles. With a view to improving the polishing rate in polishing a patterned film with minimal adverse influences on the dispersibility, preferred among them are a picolinic acid and a glutamic acid.

The polishing slurry of the embodiment may further contain a nonionic polymer. Addition of a nonionic polymer imparts material selectivity (high polishing rate on one material compared to the other) to the slurry for polishing a patterned wafer. Examples of the nonionic polymer that can be post-added to the polishing slurry include polyvinylpyrrolidone (PVP), polyvinylpolypyrrolidone (PVPP), and hydroxyethyl cellulose (HEC). Among them PVP is preferably used because it has small pattern dependency and is nonionic, i.e., less likely to influence dispersibility.

The polishing slurry of the embodiment may contain both the above described post-additive and the nonionic polymer. Combined addition of the post-additive and the nonionic polymer imparts selectivity in the material of a surface being polished.

The concentration of the additive present in a free state in the polishing slurry of the embodiment is preferably 0.01 to 1 mass%, more preferably 0.05 to 0.5 mass%, relative to the total mass of the slurry. According to the results of Examples 1 and 7 given later, the amount of picolinic acid or glutamic acid present in a free state in the liquid (supernatant liquor) of the slurry is smaller than that of picolinic acid or glutamic acid coating the cerium oxide particles. In addition to this fact, in the present embodiment, the dispersion of abrasive grain produced by the above described method is diluted with a dispersing medium, such as water, before use as a polishing slurry. Therefore, the amount of the additive, such as picolinic acid or glutamic acid, remaining in a free state in the system of producing abrasive grains is and becomes extremely small relative to the total mass of the polishing slurry, and the amount of the additive in a free state eventually turns out to mean substantially the amount of the post-additive that is post-added to the polishing slurry of the embodiment.

The concentration of the nonionic polymer in the polishing slurry of the embodiment is preferably 0.01 to 1 mass%, more preferably 0.05 to 0.5 mass%, relative to the total mass of the slurry.

The polishing slurry of the invention may contain other additives in addition to water, the additive capable of causing the inorganic abrasive particles to have a positive charge, and the nonionic polymer unless the addition results in reduction of polishing performance. Additives other than the additive causing a positive charge include viscosity modifiers, chelating agents, antifoaming agents, surfactants, and corrosion inhibitors.

The cerium oxide particle in the polishing slurry of the invention has a positive zeta potential at pH 8 or lower and preferably has a positive zeta potential even at pH higher than 8. While it is preferred for remarkably producing the effects of the invention that the zeta potential be positive in the entire range of pH of 8 or lower, the effects of the invention are sufficiently produced in so far as the zeta potential is positive in a pH range of from 3 to 8. Specifically, the absolute value of the zeta potential at pH 8 is not particularly limited as long as it is positive, and a higher zeta potential is more preferred. Specifically, the zeta potential at pH 8 is preferably +10 mV or higher, more preferably +20 mV or higher. The zeta potential at pH lower than 8, e.g., at pH 7 is not particularly limited as long as it is positive, and a higher zeta potential is more preferred. Specifically, the zeta potential at pH 7 is preferably +20 mV or higher, more preferably +30 mV or higher. As stated above, the zeta potential is preferably positive even at a pH higher than 8. Specifically, the zeta potential is preferably positive at a pH higher than 8 and not higher than 9. A higher zeta potential at pH 9 is more preferred. Specifically, the zeta potential at pH 9 is preferably +0 mV or higher. The maximum zeta potential practically reachable by cerium oxide particles in an aqueous solution adjusted to any pH value would be about +60 mV. Note that the terms "pH" and "zeta potential" as used herein are values measured in a polishing slurry at 25°C before starting a polishing operation. The pH of the polishing slurry may be adjusted by the addition of an adjusted amount of a pH adjustor, such as nitric acid, acetic acid, potassium hydroxide, or aqueous ammonia in the same manner as for the pH adjustment of the aqueous solution containing the abrasive grains of the invention.

The effect of the positive zeta potential of the cerium oxide particles in the polishing slurry of the embodiment is considered as follows: when the surface to be polished has a negative zeta potential, the cerium oxide particles as an abrasive are easily adsorbed electrostatically onto the surface to provide many cutting edges, whereby chemical mechanical polishing is accelerated. From this viewpoint, the polishing slurry of the embodiment is preferably used to polish a surface having a negative zeta potential at pH 3 or higher at which the slurry is used, more preferably used to polish a surface having a negative zeta potential at pH 5 or higher. Conversely, if the zeta potential of the surface to be polished is positive, the opposite effect may result. Nevertheless, the contrast between the strong and weak effects may be taken advantage of in controlling precision polishing characteristics.

The pH of the polishing slurry of the embodiment is preferably in the range of from 6 to 8 in the interests of improving the polishing rate, while varying depending on the material to be polished. Although the pH range recited is not the best range for the cerium oxide particles to have the highest zeta potential, the polishing rate achieved in a slurry pH range of 6 to 8 is higher than that in a slurry pH range of 4.5 to 6 and still higher than that in a slurry pH range of 3 to 4.5 partly because of the relationship with the polishing pad. At a pH 4.5 or lower, the slurry has the advantage that the amount of charge of cerium oxide particles is maintained high. However, in the case when the surface to be polished is, for example, a silicon oxide film, the polishing rate decreases because the zeta potential of the silicon oxide film approaches zero at a pH 4.5 or lower, and therefore, a pH higher than 4.5 is more advantageous for producing the inhibitory effect on the occurrence of polishing defects. Nonetheless, the polishing slurry of the embodiment sufficiently accomplishes both the prevention of defects and the improvement in polishing rate even in a pH range of 3 to 4.5. The degree of the accomplishment is higher in a pH range of 4.5 to 6 and still higher in a pH range of 6 to 8.

The invention also provides a method for polishing a surface using the polishing slurry of the invention. Examples of the material to be polished include an oxide film, e.g., SiO₂, in an STI process in semiconductor fabrication, an oxide film, e.g., SiO₂, in an ILD process in semiconductor fabrication, an oxide film, e.g., SiO₂, in power device fabrication, an oxide film, e.g., SiO₂, in SAW or BAW device fabrication, an oxide film, e.g., SiO₂, in sensor (such as position sensors, angle sensors, acceleration sensors, and magnetic sensors) fabrication, and an oxide film, e.g., SiO₂, in optical device (such as LEDs and LDs) fabrication.

The method for polishing a surface using the polishing slurry is preferably carried out by, for example, contacting a surface to be polished of a workpiece with a polishing pad of a conventionally known polishing machine and polishing the surface by the relative movement between the workpiece and the pad while feeding the polishing slurry to the pad. More specifically, a workpiece is held by a template of a single side polishing machine, and the surface of the workpiece is polished by the relative movement between the workpiece and the pad which is disposed on the platen of the polishing machine, while dropwise feeding the polishing slurry of the invention onto the pad. Otherwise, the workpiece is held by a carrier of a double side polishing machine, and both sides of the workpiece is polished by the relative movement between the workpiece and the polishing pads disposed on the upper and lower platens while supplying the polishing slurry between the upper and lower pads.

### Examples

The invention will now be illustrated in greater detail by way of examples, but it should be understood that the invention is not limited thereto. Unless otherwise noted, all the percents are by mass.

### Example 1

Cerium oxide with an average particle size D₅₀ of 10 µm and a purity of 99.99% which was prepared from cerium nitrate as a starting material was put in distilled water to which picolinic acid had been added and wet ground in a bead mill in the presence of picolinic acid using 1 mm-diameter beads from Nikkato Corp. to prepare a polishing slurry of Example 1. The cerium oxide particles of the resulting slurry had an average particle size D₅₀ of 110 nm, and the content of the ground cerium oxide particles in the slurry was 0.6% relative to the total mass of the slurry. The amount of picolinic acid added was 1.25% relative to the mass of the cerium oxide. The whole amount (yield) of the polishing slurry of Example 1 was 4.0 kg. The pH of the slurry was adjusted to the value shown in Table 1 below using nitric acid or a potassium hydroxide aqueous solution as a pH adjustor. The pH of the slurry was measured by the method described later.

### Examples 2 to 6

Polishing slurries of Examples 2 to 6 were prepared in the same manner as in Example 1, except for adjusting the pH of the slurry as shown in Table 1 using nitric acid or a potassium hydroxide aqueous solution as a pH adjustor.

### Example 7

Cerium oxide with an average particle size D₅₀ of 10 µm and a purity of 99.99% which was prepared from cerium nitrate as a starting material was put in distilled water to which glutamic acid had been added and wet ground in a bead mill in the presence of glutamic acid to prepare a polishing slurry of Example 7. The same beads as used in Example 1 were used. The cerium oxide particles of the resulting slurry had an average particle size D₅₀ of 110 nm, and the content of the cerium oxide particles in the slurry was 0.6% relative to the total mass of the slurry. The amount of glutamic acid added was 1.25% relative to the mass of the cerium oxide particles. The whole amount (yield) of the polishing slurry of Example 7 was 4.0 kg. The pH of the slurry was adjusted to the value shown in Table 1 below using nitric acid or a potassium hydroxide aqueous solution as a pH adjustor. The pH of the slurry was measured by the method described below.

### Examples 8 to 12

Polishing slurries of Examples 8 to 12 were prepared in the same manner as in Example 7, except for adjusting the pH of the slurry as shown in Table 1 using nitric acid or a potassium hydroxide aqueous solution as a pH adjustor.

### Comparative Example 1

Cerium oxide with an average particle size D₅₀ of 10 µm and a purity of 99.99% which was prepared by firing cerium nitrate as a starting material was put in distilled water to which polyacrylic acid commonly used as a dispersant for inorganic particles had been added in place of picolinic acid or glutamic acid and wet ground in a bead mill in the presence of the polyacrylic acid to prepare a polishing slurry of Comparative Example 1. The same beads as used in Example 1 were used. The cerium oxide particles of the resulting slurry had an average particle size D₅₀ of 110 nm, and the content of the cerium oxide particles in the slurry was 0.6% relative to the total mass of the slurry. The amount of the polyacrylic acid added was 1.25% relative to the mass of the cerium oxide particles. The whole amount of the polishing slurry of Comparative Example 1 was 4.0 kg. The pH of the slurry was adjusted to the value shown in Table 1 below using nitric acid or a potassium hydroxide aqueous solution as a pH adjustor. The pH of the slurry was measured by the method described below.

### Comparative Example 2

Cerium oxide with an average particle size D₅₀ of 110 nm and a purity of 99.99% which was prepared by firing cerium nitrate as a starting material was put in distilled water to which polyacrylic acid commonly used as a dispersant for inorganic particles had been added and wet ground in a bead mill in the presence of the polyacrylic acid. The same beads as used in Example 1 were used. Picolinic acid was added to the resultant to give a polishing slurry of Comparative Example 2. The cerium oxide particles of the resulting polishing slurry had an average particle size D₅₀ of 110 nm, and the content of the cerium oxide particles in the slurry was 0.6% relative to the mass of the slurry. The amount of polyacrylic acid added was 1.25% relative to the mass of the cerium oxide particles, and the amount of picolinic acid post-added was 1.25% relative to the mass of the cerium oxide particles. The whole amount of the polishing slurry of Comparative Example 2 was 4.0 kg. The pH of the polishing slurry was adjusted to the value shown in Table 1 using nitric acid or a potassium hydroxide aqueous solution as a pH adjustor. The pH of the slurry was measured by the method described below.

### Comparative Example 3

Cerium oxide with an average particle size D₅₀ of 10 µm and a purity of 99.99% which was prepared by firing cerium nitrate as a starting material was put in distilled water to which polyacrylic acid commonly used as a dispersant for inorganic particles had been added and wet ground in a bead mill in the presence of the polyacrylic acid. The same beads as used in Example 1 were used. Glutamic acid was added to the resultant to give a polishing slurry of Comparative Example 3. The cerium oxide particles of the resulting polishing slurry had an average particle size D₅₀ of 110 nm, and the content of the cerium oxide particles was 0.6% relative to the mass of the polishing slurry. The amount of polyacrylic acid added was 1.25% relative to the mass of the cerium oxide particles, and the amount of glutamic acid post-added was 1.25% relative to the mass of the cerium oxide particles. The whole amount of the polishing slurry of Comparative Example 3 was 4.0 kg. The pH of the polishing slurry was adjusted to the value shown in Table 1 using nitric acid or a potassium hydroxide aqueous solution as a pH adjustor. The pH of the slurry was measured by the method described below.

### Evaluation:

The polishing slurries obtained in Examples 1 to 12 and Comparative Examples 1 to 3 were evaluated by determining the zeta potential of the cerium oxide particles in the slurry by the method below. The results obtained are shown in Table 1. The amount of picolinic acid or glutamic acid on the cerium oxide particles in the polishing slurry of Examples 1 and 7 was determined through neutralization titration in accordance with the method below. The results are shown in Table 1. The polishing slurries of Examples 1 to 12 and Comparative Examples 1 to 3 were evaluated in terms of polishing rate and scratch defect in accordance with the methods below, and the results obtained are shown in Table 1.

### [Zeta potential]

The zeta potential of cerium oxide particles in each polishing slurry before the start of a polishing test at 25°C was determined using a Zeta-potential & Particle Size Analyzer ELSZ available from Otsuka Electronics Co., Ltd. based on the principle of electrophoretic light scattering.

### [pH]

The pH of each polishing slurry before the start of a polishing test at 25°C was measured using a pH/Ion Meter D51 (electrode model: 9625-10D) from Horiba, Ltd.

### [Amount of picolinic acid or glutamic acid on cerium oxide particles (neutralization titration)]

The polishing slurries of Examples 1 and 7 were each left to stand at room temperature (20°C) and 50% RH for 2 weeks to allow the cerium oxide particles to settle. A hundred grams of the supernatant liquor was harvested and centrifuged in a centrifuge CN-2060 from AS ONE Corp. at 3500 rpm for 20 minutes. Ninety-five grams of the thus separated supernatant liquor was harvested as a sample for analysis. A 0.1% potassium hydroxide aqueous solution was dropped into the sample. The amount of the potassium hydroxide aqueous solution dropped until the pH of the sample reached 7 was recorded to calculate the amount of the picolinic acid or glutamic acid in a free state (remaining non-adsorbed). Separately, an aqueous solution of picolinic acid having the same concentration as used in Example 1 was prepared as Reference Example 1. A 0.1% potassium hydroxide aqueous solution was dropped into the aqueous solution of Reference Example 1, and the amount of the potassium hydroxide aqueous solution dropped until the pH reached 7 was recorded (see Table 24 below). Similarly, an aqueous solution of glutamic acid having the same concentration as used in Example 7 was prepared as Reference Example 2. A 0.1% potassium hydroxide aqueous solution was dropped into the aqueous solution of Reference Example 2, and the amount of the potassium hydroxide aqueous solution dropped until the pH reached 7 was recorded (see Table 2).

### [Polishing rate]

A polishing test was performed using each polishing slurry according to the following procedures. A 6-inch silicon substrate having a thermal oxide (SiO₂) film on its surface was provided as a workpiece to be polished. A single side polishing machine SPP600S GRIND-X from Okamoto Machine Tool Works, Ltd. equipped with a polishing pad IC-1400 from Nitta Haas Inc. was used. The polishing conditions were as follows: a downward pressure of 3 psi (214 gf/cm²), a rotation speed of polishing head of 83 rpm, a rotation speed of platen of 89 rpm, a slurry feed rate of 200 ml/min, and a polishing time of 1 minute. The polishing rate per minute was calculated from the difference in thickness of the workpiece between before and after the polishing as obtained by the measurements taken using an interference thickness meter NanoSpec 6100 from NANO Metrics Inc.

### [Scratch defect]

After the polishing rate determination, the polished surface was observed at three different sites (10 µm by 10 µm field each) using an atomic force microscope Dimension Icon AFM from Bruker AXS to inspect for scratches. The slurry was evaluated according to the following rating system.
S: In the three sites, the total number of scratches with a maximum width of 0.1 µm or greater (large scratches) is zero, and the total number of scratches with a maximum width of 0.01 µm or greater and smaller than 0.1 µm (medium scratches) is zero.
A: In the three sites, the total number of large scratches is zero, and the total number of medium scratches is one.
B: In the three sites, the total number of large scratches is one, and the total number of medium scratches is one.

**Table 1-1**

| | Example 1 | Example 2 | Example 3 | Example 4 | Example 5 | Example 6 |
|---|---|---|---|---|---|---|
| Additive in Grinding (wt%) | picolinic acid (1.25) | picolinic acid (1.25) | picolinic acid (1.25) | picolinic acid (1.25) | picolinic acid (1.25) | picolinic acid (1.25) |
| Additive in Slurry Preparation (wt%) | none | none | none | none | none | none |
| Amount of CeO₂ Particles (wt%) | 0.6 | 0.6 | 0.6 | 0.6 | 0.6 | 0.6 |
| D₅₀ of CeO₂ Particles (nm) | 110 | 110 | 110 | 110 | 110 | 110 |
| pH of Slurry | 6.0 | 5.0 | 5.5 | 7.0 | 8.0 | 4.0 |
| Zeta Potential (mV) | 50 | 47 | 49 | 43 | 34 | 44 |
| Amount of titrant (KOH) (g) | 1.1 | - | - | - | - | - |
| Amount of Residual Free Picolinic Acid (wt%) | 31 | - | - | - | - | - |
| Amount of Coating (wt%) | 0.86 | - | - | - | - | - |
| Polishing Rate (nm/min) | 1010 | 750 | 1112 | 845 | 853 | 508 |
| Scratch Defect | S | A | A | A | A | B |

**Table 1-2**

| | Example 7 | Example 8 | Example 9 | Example 10 | Example 11 | Example 12 |
|---|---|---|---|---|---|---|
| Additive in Grinding (wt%) | glutamic acid (1.25) | glutamic acid (1.25) | glutamic acid (1.25) | glutamic acid (1.25) | glutamic acid (1.25) | glutamic acid (1.25) |
| Additive in Slurry Preparation (wt%) | none | none | none | none | none | none |
| Amount of CeO₂ Particles (wt%) | 0.6 | 0.6 | 0.6 | 0.6 | 0.6 | 0.6 |
| D₅₀ of CeO₂ Particles (nm) | 110 | 110 | 110 | 110 | 110 | 110 |
| pH of Slurry | 6.0 | 5.0 | 5.5 | 7.0 | 8.0 | 4.0 |
| Zeta Potential (mV) | 47 | 47 | 47 | 34 | 14 | 47 |
| Amount of Titrant (KOH) (g) | 1.2 | - | - | - | - | - |
| Amount of Residual Free Glutamic Acid (wt%) | 33 | - | - | - | - | - |
| Amount of Coating (wt%) | 0.84 | - | - | - | - | - |
| Polishing Rate (nm/min) | 960 | 713 | 1075 | 796 | 808 | 502 |
| Scratch Defect | S | A | A | A | A | B |

**Table 1-3**

| | Comparative Example 1 | Comparative Example 2 | Comparative Example 3 |
|---|---|---|---|
| Additive in Grinding (wt%) | polyacrylic acid (1.25) | polyacrylic acid (1.25) | polyacrylic acid (1.25) |
| Additive in Slurry Preparation (wt%) | none | picolinic acid (1.25) | glutamic acid (1.25) |
| Amount of CeO₂ Particles (wt%) | 0.6 | 0.6 | 0.6 |
| D₅₀ of CeO₂ Particles (nm) | 110 | 110 | 110 |
| pH of Slurry | 6.0 | 6.0 | 6.0 |
| Zeta Potential (mV) | -46 | -46 | -45 |
| Amount of Titrant (KOH) (g) | - | - | - |
| Amount of Residual Free Picolinic or Glutamic Acid (wt%) | - | - | - |
| Amount of Coating (wt%) | - | - | - |
| Polishing Rate (nm/min) | 391 | 331 | 438 |
| Scratch Defect | A | A | A |

**Table 2**

| | Reference Example 1 | Reference Example 2 |
|---|---|---|
| Acid | picolinic acid | glutamic acid |
| Amount of Titrant (KOH) (g) | 3.6 | 3.6 |
| Amount of Free Picolinic or Glutamic Acid (%) | 100 | 100 |

It is seen from Table 1 that the cerium oxide particles in the polishing slurries of Examples 1 to 12 had a positive zeta potential at pH 8 or lower. In contrast, those of Comparative Examples 1 to 3 had a negative zeta potential at pH 8 or lower.

As shown in Tables 1 and 2, the amount of the potassium hydroxide aqueous solution dropped into the picolinic acid aqueous solution of Reference Example 1 (the abundance of picolinic acid: 100%) until pH 7 was reached was 3.6 g. On the other hand, as shown in Table 1, the amount dropped into the supernatant liquor of Example 1 was 1.1 g. That is, the picolinic acid abundance in the supernatant liquor of Example 1 decreased to 31% ((100/3.6) × 1.1), from which it is estimated that the rest (69%) of the picolinic acid had been adsorbed onto the surface of the cerium oxide particles. The amount of picolinic acid added to the grinding system being 1.25%, the amount of picolinic acid coating the cerium oxide particles is calculated to be 0.86%. As shown in Table 1, on the other hand, the cerium oxide particles in the polishing slurry of Comparative Example 2 have a negative zeta potential at pH 8 or lower, and picolinic acid is not adsorbed onto the cerium oxide particles.

Likewise, as shown in Tables 1 and 2, the amount of the potassium hydroxide aqueous solution dropped into the glutamic acid aqueous solution of Reference Example 2 (the abundance of glutamic acid: 100%) until pH 7 was reached was 3.6 g. On the other hand, the amount dropped into the supernatant liquor of Example 7 was 1.2 g. That is, the glutamic acid abundance in the supernatant liquor of Example 7 decreased to 33% ((100/3.6) × 1.2), from which it is estimated that the rest (67%) of the glutamic acid had been adsorbed onto the surface of the cerium oxide particles. The amount of glutamic acid added to the grinding system being 1.25%, the amount of glutamic acid coating the cerium oxide particles is calculated to be 0.84%. As shown in Table 1, on the other hand, the cerium oxide particles in the polishing slurry of Comparative Example 3 have a negative zeta potential at pH 8 or lower, and glutamic acid is not adsorbed onto the cerium oxide particles.

As is apparent from the results in Table 1, the polishing slurries of Examples 1 to 12 prove superior in achieving improved polishing rates with reduced occurrence of scratch defects to those of Comparative Examples 1 to 3, with the average particle size of cerium oxide particles being equal.

### Example 13

Cerium oxide with an average particle size D₅₀ of 10 µm and a purity of 99.99% which was prepared from cerium nitrate as a starting material was put in distilled water to which picolinic acid had been added and wet ground in a bead mill in the presence of picolinic acid using 1 mm-diameter beads from Nikkato Corp to obtain a slurry. The resulting slurry was diluted with water to provide a polishing slurry of Example 13. No post-additive was added. The cerium oxide particles of the resulting polishing slurry of Example 13 had an average particle size D₅₀ of 17 nm, and the content (concentration) of the cerium oxide particles in the polishing slurry was 0.15% relative to the total mass of the polishing slurry. The amount of picolinic acid added was 0.002% relative to the total mass of the polishing slurry. The whole amount (yield) of the polishing slurry of Example 13 was 10 kg. The pH of the polishing slurry was adjusted to the value shown in Table 3 below using nitric acid or a potassium hydroxide aqueous solution as a pH adjustor. The pH of the slurry was measured by the method described above.

### Examples 14 to 17

Polishing slurries of Examples 14 to 17 were prepared in the same manner as in Example 13, except that picolinic acid was added as a post-additive to the polishing slurry of Example 13. The amount (concentration) of picolinic acid as a post-additive relative to the total mass of the polishing slurry were as shown in Table 3.

### Comparative Example 4

Cerium oxide with an average particle size D₅₀ of 10 µm and a purity of 99.99% which was prepared by firing cerium nitrate as a starting material was put in distilled water to which polyacrylic acid commonly used as a dispersant for inorganic particles had been added in place of picolinic acid or glutamic acid and wet ground in a bead mill in the presence of the polyacrylic acid to obtain a slurry. The same beads as used in Example 13 were used. The resulting slurry was diluted with water to provide a polishing slurry of Comparative Example 4. No post-additive was added. The cerium oxide particles of the resulting polishing slurry had an average particle size D₅₀ of 17 nm, and the concentration (content) of the cerium oxide particles in the polishing slurry was 0.15% relative to the total mass of the polishing slurry. The amount of the polyacrylic acid added was 0.002% relative to the total mass of the polishing slurry. The whole amount (yield) of the polishing slurry of Comparative Example 4 was 10 kg. The pH of the polishing slurry was adjusted to the value shown in Table 3 using nitric acid or a potassium hydroxide aqueous solution as a pH adjustor. The pH of the slurry was measured by the method described above.

### Evaluation:

The polishing slurries obtained in Examples 13 to 17 and Comparative Example 4 were evaluated by determining the zeta potential of the cerium oxide particles therein according to the method described above. The results obtained are shown in Tables 3. The same polishing slurries were further evaluated by determining the polishing rate in polishing a substrate with a blanket film in accordance with the method below. The results are also shown in Table 3.

### [Polishing rate on blanket film substrate]

A polishing test was performed using each polishing slurry according to the following procedures. An 8-inch silicon wafer having a 1000 nm-thick SiO₂ film on its entire surface was provided as a blanket film substrate to be polished. A polishing machine F-REX® 200 from Ebara Corp. equipped with IC-1000 and SUB400, both from Nitta Haas, as an upper pad and a lower pad, respectively, was used. The polishing conditions were as follows: a polishing pressure of 3 psi (216 gf/cm²), a rotation speed of polishing head of 107 rpm, a rotation speed of platen of 100 rpm, a slurry feed rate of 200 ml/min, and a polishing time of 60 seconds. The polishing rate per minute was calculated from the difference in thickness of the substrate between before and after the polishing as obtained by the measurements taken using an interference thickness meter NanoSpec 6100 from NANO Metrics Inc.

**Table 3**

| | Example 13 | Example 14 | Example 15 | Example 16 | Example 17 | Comparative Example 4 |
|---|---|---|---|---|---|---|
| Additive in Grinding (wt%) | picolinic acid (0.002) | picolinic acid (0.002) | picolinic acid (0.002) | picolinic acid (0.002) | picolinic acid (0.002) | polyacrylic acid (0.002) |
| Additive in Slurry Prepn. (Post-additive) (wt%) | none | picolinic acid (0.02) | picolinic acid (0.06) | picolinic acid (0.12) | picolinic acid (0.25) | none |
| Amount of CeO₂ Particles (wt%) | 0.15 | 0.15 | 0.15 | 0.15 | 0.15 | 0.15 |
| D₅₀ of CeO₂ Particles (nm) | 17 | 17 | 17 | 17 | 17 | 17 |
| pH of Slurry | 6.0 | 6.0 | 6.0 | 6.0 | 6.0 | 9.5 |
| Zeta Potential (mV) | 50 | 50 | 51 | 52 | 52 | -46 |
| Polishing Rate on Blanket Film (nm/min) | 370 | 430 | 400 | 190 | 130 | 30 |

As shown in Table 3, the cerium oxide particles in the polishing slurries of Examples 13 to 17 have a positive zeta potential at pH 8 or lower. In contrast, those in the slurry of Comparative Example 4 had a negative zeta potential at pH 8 or lower. The polishing slurries of Examples 13 to 17 achieved higher polishing rates on a blanket film substrate than the slurry of Comparative Example 4. In particular, the slurries of Examples 14 and 15 achieved still higher polishing rates than that of Example 13.

### Evaluation:

The polishing slurries of Examples 13 to 17 were further evaluated in terms of polishing time in polishing a patterned substrate by the method below. The results of evaluation are shown in Table 4.

### [Polishing time on patterned substrate]

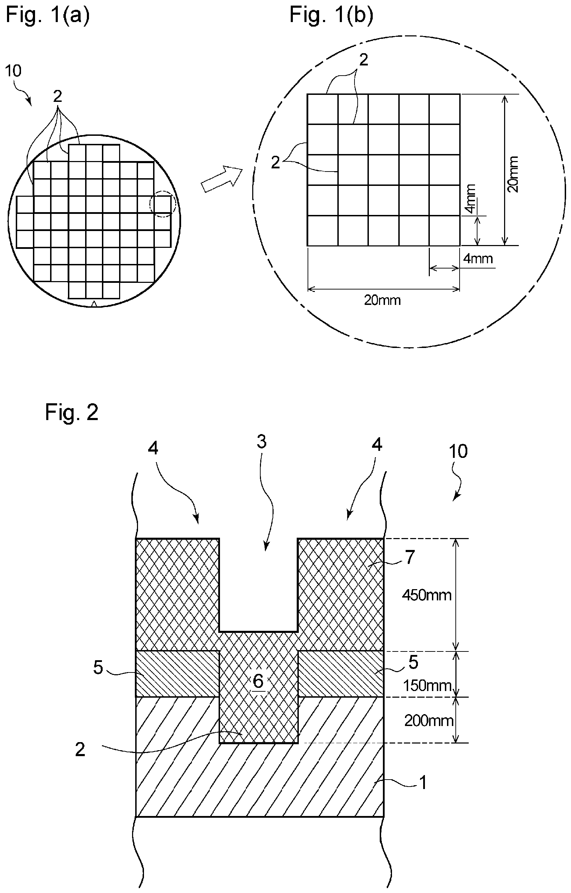

A polishing test was performed using each slurry in accordance with the following procedures. As a workpiece to be polished, an STI patterned test substrate (MIT864 mask pattern wafer from Advanced Materials Technology, Inc.) was used. The STI patterned test substrate 10 will be described with reference to Figs. 1 and 2. As illustrated in Figs. 1(a) and 2, an STI patterned test substrate 10 has an 8-inch silicon wafer 1 having a plurality of 200 nm-deep trenches 2 on its surface. The plurality of trenches 2 are arranged in a grid at a 20 mm spacing to form a plurality of 20 mm-side squares. As illustrated in Fig. 1(b), each 20 mm-side square is further divided into twenty-five 4 mm-side square regions by a plurality of 200 nm-deep trenches 2. As illustrated in Fig. 2, various patterns imitating STI patterns composed of depressions 3 and projections 4 are formed on the twenty-five regions, one pattern in one region. The individual patterns are line-and-space patterns composed of alternating depressions 3 of the same width and projections 4 of the same width. The combinations of the widths of depressions 3/projections 4 are 0 µm/4 mm, 25 µm/25 µm, 100 µm/100 µm, 500 µm/500 µm, and 4 mm/0 µm. As illustrated in Fig. 2, in each pattern, every projection 4 has a 150 nm-thick silicon nitride (SiN) film 5 as a stop layer to make a 350 nm-deep trench 6, and the overall surface of the silicon nitride film 5 and the trenches 6 is covered with a 450 nm-thick SiO₂ film 7. The individual patterns are thus formed.

The patterned substrate was polished using the same polishing machine as used in the determination of the polishing rate on the blanket film substrate under the same conditions except the polishing time as in the determination the polishing rate on the blanket film substrate. The time taken for the silicon nitride (SiN) film 5 to be exposed was measured on the regions having line-and-space patterns with the depression 3/projection 4 width combinations of 25 µm/25 µm, 100 µm/100 µm, and 500 µm/500 µm to give the polishing time on the patterned substrate.

**Table 4**

| | | Example 13 | Example 14 | Example 15 | Example 16 | Example 17 |
|---|---|---|---|---|---|---|
| Additive in Grinding (wt%) | | picolinic acid (0.002) | picolinic acid (0.002) | picolinic acid (0.002) | picolinic acid (0.002) | picolinic acid (0.002) |
| Additive in Slurry Prepn. (Post-additive) (wt%) | | none | picolinic acid (0.002) | picolinic acid (0.06) | picolinic acid (0.12) | picolinic acid (0.25) |
| Polishing Time on Patterned Substrate (sec) | 25 µm Width | 150 | 70 | 60 | 80 | 120 |
| | 100 µm Width | 150 | 70 | 60 | 80 | 120 |
| | 500 µm Width | 150 | 70 | 60 | 100 | 120 |

As can be seen from Table 4, the polishing slurries of Examples 14 to 17 achieve polishing in shorter times on every line-and-space pattern of a patterned substrate than the slurry of Example 13.

### Example 18

Cerium oxide with an average particle size D₅₀ of 10 µm and a purity of 99.99% which was prepared from cerium nitrate as a starting material was put in distilled water to which picolinic acid had been added and wet ground in a bead mill in the presence of picolinic acid using 1 mm-diameter beads from Nikkato Corp to obtain a slurry. To the resulting slurry were added picolinic acid and polyvinylpyrrolidone (PVP) as post-additives to provide a polishing slurry of Example 18. The cerium oxide particles of the resulting polishing slurry of Example 18 had an average particle size D₅₀ of 17 nm, and the concentration (content) of the cerium oxide particles in the polishing slurry was 0.15% relative to the total mass of the polishing slurry. The amount of picolinic acid added to the grinding system was 0.002% relative to the total mass of the polishing slurry. The whole amount (yield) of the polishing slurry of Example 18 was 10 kg. The amount (concentration) of picolinic acid added as a post-additive was 0.25% relative to the total mass of the polishing slurry. The amount (concentration) of the PVP added was 0.1% relative to the total mass of the polishing slurry.

### Evaluation:

The polishing slurries of Examples 17 and 18 were evaluated in terms of polishing rate on a patterned substrate by the method below. The results obtained are shown in Table 5.

### [Polishing rate on patterned substrate]

A polishing test was performed using each polishing slurry in accordance with the following procedures. As a workpiece to be polished, the same STI patterned test substrate 10 as used in the determination of polishing time on a patterned substrate (shown in Tables 1 and 2) was used. Polishing was performed using the same polishing machine under the same conditions as in the determination of polishing rate on a blanket film substrate. The thickness of the substrate was measured at the regions having line-and-space patterns with the depression 3/projection 4 width combinations of 25 µm/25 µm, 100 µm/100 µm, 500 µm/500 µm, and 0 µm/4 mm, and the polishing rate per minute was calculated from the difference in thickness between before and after the polishing. The results obtained are shown in Table 5.

**Table 5**

| | | Example 17 | Example 18 |
|---|---|---|---|
| Additive in Grinding (wt%) | | picolinic acid (0.002) | picolinic acid (0.002) |
| Additive in Slurry Preparation (Post-Additive) (wt%) | | picolinic acid (0.25) | picolinic acid (0.25) PVP (0.1) |
| Polishing Rate on Patterned Substrate (nm/min) | 25 µm Width | 430 | 130 |
| | 100 µm Width | 320 | 120 |
| | 500 µm Width | 210 | 150 |
| | 4 mm Width | 130 | 130 |
| | Δ(Max-Min) (Planarity) | 300 | 30 |

It is seen from Table 5 that the polishing slurry of Example 18 achieves a constant polishing rate on every line-and-space pattern of the patterned substrate as compared with that of Example 17. Specifically, the polishing rate of the polishing slurry of Example 18 proved constant on each of the regions of the patterned substrate having line-and-space patterns with the depression 3/projection 4 width combinations of 0 µm/4 mm, /25 µm/25 µm, 100 µm/100 µm, and 500 µm/500 µm.

### Example 19

Cerium oxide with an average particle size D₅₀ of 10 µm and a purity of 99.99% which was prepared from cerium nitrate as a starting material was put in distilled water to which picolinic acid had been added and wet ground in a bead mill in the presence of picolinic acid using 1 mm-diameter beads from Nikkato Corp to obtain a slurry. To the resulting slurry were added picolinic acid and PVP as post-additives to provide a polishing slurry of Example 19. The cerium oxide particles of the polishing slurry of Example 19 had an average particle size D₅₀ of 17 nm, and the concentration (content) of the cerium oxide particles in the polishing slurry was 0.15% relative to the total mass of the polishing slurry. The amount of picolinic acid added before grinding was 0.002% relative to the total mass of the polishing slurry. The whole amount (yield) of the polishing slurry of Example 19 was 10 kg. The amount (concentration) of the post-added picolinic acid was 0.25% relative to the total mass of the polishing slurry. The amount (concentration) of the PVP added was 0.03% relative to the total mass of the polishing slurry.

### Evaluation:

The polishing slurries of Examples 13, 17, and 19 were evaluated for polishing selectivity on blanket film substrates having different materials to be polished by the method below. The results are shown in Table 6.

### [Polishing rate on blanket film substrate]

A polishing test was performed using each polishing slurry in accordance with the following procedures. As a workpiece to be polished, three types of blanket film substrate were provided, including an 8-inch silicon wafer, an 8-inch silicon wafer having thereon a 1000 nm-thick blanket SiO₂ film (SiO₂ film substrate), and an 8-inch silicon wafer having thereon a 100 nm-thick blanket silicon nitride (SiN) film (SiN film substrate). Polishing was performed using the same polishing machine under the same conditions as in the determination of polishing rate on a blanket film substrate. The thickness of each substrate was measured, and the polishing rate per minute was calculated from the difference in thickness between before and after the polishing. The results obtained are shown in Table 6.

**Table 6**

| | | Example 13 | Example 17 | Example 19 |
|---|---|---|---|---|
| Additive in Grinding (wt%) | | picolinic acid (0.002) | picolinic acid (0.002) | picolinic acid (0.002) |
| Additive in Slurry Preparation (Post-additive) (wt%) | | none | picolinic acid (0.25) | picolinic acid (0.25) PVP (0.03) |
| Amount of CeO₂ Particles (wt%) | | 0.15 | 0.15 | 0.15 |
| D₅₀ of CeO₂ Particles (nm) | | 17 | 17 | 17 |
| pH of Polishing Slurry | | 6.0 | 6.0 | 6.0 |
| Polishing Rate on Different Materials of Blanket Film | SiO2 Film (nm/min) | 630 | 180 | 30 |
| | SiN Film (nm/min) | 280 | 210 | 150 |
| | Poly silicon (nm/min) | 70 | 3 | 3 |
| | Selectivity to SiO2 | 9 | 60 | 10 |
| | Selectivity to SiN | 4 | 70 | 50 |
| | Selectivity to Polysilicon | 1 | 1 | 1 |

As can be seen from Table 6, the polishing slurries of Examples 17 and 19 achieve higher polishing rates on the SiN film substrate than on the 8-inch silicon wafer as compared with the polishing slurry of Example 13. It is also seen that the polishing slurry of Example 17 achieves a higher polishing rate on the SiO₂ film substrate than on the 8-inch silicon wafer as compared with the polishing slurry of Example 13.

### Example 20

Cerium oxide with an average particle size D₅₀ of 10 µm and a purity of 99.99% which was prepared from cerium nitrate as a starting material was put in distilled water to which glutamic acid had been added and wet ground in a bead mill in the presence of glutamic acid using 1 mm-diameter beads from Nikkato Corp to obtain a slurry. The resulting slurry was diluted with water to provide a polishing slurry of Example 20. No post-additive was added. The cerium oxide particles of the polishing slurry of Example 20 had an average particle size D₅₀ of 40 nm, and the concentration (content) of the cerium oxide particles in the polishing slurry was 0.15% relative to the total mass of the polishing slurry. The amount of glutamic acid added was 0.002% relative to the total mass of the polishing slurry. The whole amount (yield) of the polishing slurry of Example 20 was 10 kg.

### Comparative Example 5

Cerium oxide with an average particle size D₅₀ of 10 µm and a purity of 99.99% which was prepared by firing cerium nitrate as a starting material was put in distilled water to which polyacrylic acid commonly used as a dispersant for inorganic particles had been added in place of picolinic acid or glutamic acid and wet ground in a bead mill in the presence of the polyacrylic acid to obtain a slurry. The same beads as used in Example 20 were used. The resulting slurry was diluted with water to yield a polishing slurry of Comparative Example 5. No post-additive was added. The cerium oxide particles of the resulting polishing slurry of Comparative Example 5 had an average particle size D₅₀ of 165 nm, and the concentration (content) of the cerium oxide particles in the slurry was 0.15% relative to the total mass of the slurry. The amount of the polyacrylic acid added was 0.002% relative to the total mass of the slurry. The whole amount (yield) of the polishing slurry of Comparative Example 5 was 10 kg.

### [Polishing rate on patterned substrate]

A polishing test was performed using each polishing slurry in accordance with the following procedures. As a workpiece to be polished, the same STI patterned test substrate 10 as used in the determination of polishing time on a patterned substrate (shown in Tables 1 and 2) was used. Polishing was performed using the same polishing machine under the same conditions as in the determination of polishing rate on a blanket film substrate. The thickness of the substrate was measured at the regions having line-and-space patterns with the depression 3/projection 4 width combinations of 25 µm/25 µm, 100 µm/100 µm, 500 µm/500 µm, and 0 µm/4 mm, and the polishing rate per minute was calculated from the difference in thickness between before and after the polishing. The results obtained are shown in Table 7.

**Table 7**

| | | Example 20 | Compa. Example 5 |
|---|---|---|---|
| Additive in Grinding (wt%) | | glutamic acid (0.002) | polyacrylic acid (0.002) |
| Additive in Slurry Preparation (Post-Additive) (wt%) | | none | none |
| Polishing Rate on Patterned Substrate (nm/min) | 25 µm Width | 20 | 80 |
| | 100 µm Width | 20 | 80 |
| | 500 µm Width | 80 | 120 |
| | 4 mm Width | 140 | 120 |

It is seen from Table 7 that the polishing slurry of Comparative Example 5 is designed to exhibit a constant polishing rate on every line-and-space pattern of the patterned test substrate by virtue of the use of cerium oxide particles with an average particle size D₅₀ as large as 165 nm. In contrast, the polishing slurry of Example 20, despite the use of cerium oxide particles with a small average particle size D₅₀ of 40 nm, shows higher polishing rates on the regions having line-and-space patterns with the depression 3/projection 4 width combinations of 500 µm/500 µm and 0 µm/4 mm than on the regions with the depression 3/projection 4 width combinations of 25 µm/25 µm and 100 µm/100 µm.

As can be seen from the results in Tables 1 through 7 that the polishing slurries of Examples 1 to 20 exhibit various characteristics. Therefore, the polishing slurry according to the invention has high capability of having its characteristics adjusted according to users' needs.

### Industrial Applicability

The invention provides an abrasive grain and a polishing slurry containing the abrasive grain that bring about an improved polishing rate while preventing the occurrence of polishing defects. The invention also provides a polishing method that uses the polishing slurry and improves a polishing rate while preventing the occurrence of polishing defects. The invention also provides a method for producing such an abrasive grain.

## Claims

1. An abrasive grain comprising an additive-coated inorganic abrasive particle having a positive zeta potential at pH 8 or lower.

2. The abrasive grain according to claim 1, wherein the additive is a picolinic acid or a glutamic acid, and the inorganic abrasive particle is a cerium oxide particle.

3. The abrasive grain according to claim 2, being produced by a method comprising wet grinding cerium oxide in the presence of the picolinic acid or the glutamic acid.

4. A polishing slurry comprising the abrasive grain according to any one of claims 1 to 3.

5. A polishing slurry comprising an abrasive grain, an additive, and water,
the abrasive grain comprising an additive-coated inorganic abrasive particle having a positive zeta potential at pH 8 or lower, and
the additive being capable of developing a positive charge in the polishing slurry.

6. The polishing slurry according to claim 5, wherein the additive is a picolinic acid or a glutamic acid, and the inorganic abrasive particle is a cerium oxide particle.

7. The polishing slurry according to claim 5 or 6, further comprising a nonionic polymer.

8. The polishing slurry according to any one of claims 5 to 7, containing the additive in a free state in a concentration of 0.01% to 1% by mass relative to the total mass of the slurry.

9. The polishing slurry according to any one of claims 5 to 8, being for use in polishing a surface having a negative zeta potential at pH 3 or higher.

10. The polishing slurry according to any one of claims 4 to 9, having a pH of 3 to 9.

11. The polishing slurry according to any one of claims 4 to 9, having a pH of 6 to 8.

12. A method for polishing a surface, comprising polishing the surface using the polishing slurry according to any one of claims 4 to 11.

13. A method for producing an abrasive grain comprising a cerium oxide particle coated with a picolinic acid or a glutamic acid and having a positive zeta potential at pH 8 or lower, the method comprising wet grinding cerium oxide in the presence of a picolinic acid or a glutamic acid.
